# EUROPÄISCHE PATENTSCHRIFT

(11) **EP 3 236 564 B1**
(45) Veröffentlichungstag und Bekanntmachung des Hinweises auf die Patenterteilung: **29.04.2020**
(21) Anmeldenummer: 17165737.2
(22) Anmeldetag: 10.04.2017
(51) Int. Cl.: H02K 3/52, H02K 11/33, H05K 3/32, H05K 1/18, H01R 4/242, H01R 12/50

(54) **KONTAKTIERUNGSANORDNUNG ZWISCHEN EINEM STATOR UND EINER LEITERPLATTE**
CONTACT-MAKING ARRANGEMENT BETWEEN A STATOR AND A PRINTED CIRCUIT BOARD
SYSTÈME DE MISE EN CONTACT ENTRE UN STATOR ET UN CIRCUIT IMPRIMÉ

(30) Priorität: 22.04.2016 DE 102016107543
(43) Veröffentlichungstag der Anmeldung: 25.10.2017
(73) Patentinhaber: ebm-papst Mulfingen GmbH & Co. KG, 74673 Mulfingen (DE)
(72) Erfinder: MEZGER, Paul, 97980 Bad Mergentheim-Rengershausen (DE); RYBAK, Alexander, 97980 Bad Mergentheim (DE)
(74) Vertreter: Staeger & Sperling Partnerschaftsgesellschaft mbB

(56) Entgegenhaltungen:
- EP-A1- 1 037 312
- WO-A2-2013/098001
- DE-A1-102015 208 425
- DE-U1- 20 212 273

## Beschreibung

Die Erfindung betrifft einen Stator mit einer Leiterplatte sowie ein Verfahren zum Herstellen einer Kontaktierungsanordnung zwischen einem Stator und einer Leiterplatte.

Elektromotoren nach dem Stand der Technik bestehen im Wesentlichen aus zwei Komponenten, nämlich dem Stator mit seinen Wicklungen und dem Rotor.

Der Stator eines Elektromotors steht in einer festen Position, während sich der Rotor relativ zum Stator drehen kann. Am Stator befinden sich Wicklungsrahmen, um die Lackdrähte gewickelt sind. Solche Wicklungen werden nachfolgend als Wicklungsanordnung oder allgemein als Statorwicklung bezeichnet.

Die jeweils zu einer Spule gewickelten Lackdrähte, die von diesen Wicklungsrahmen wegführen, müssen mit der Leitungsstruktur im Inneren des Elektromotors elektrisch verbunden werden, damit die Wicklungen bestromt werden können.

Die elektrische Verbindung der Lackdrähte mit der Leitungsstruktur wird üblicherweise durch Schweißen oder Löten hergestellt. Hierzu werden zunächst die Lackdrähte mit Zwischenklemmen und die Zwischenklemmen wiederum mit einer weiteren Leitungsstruktur durch den Verbindungsprozess verbunden.

Dies hat jedoch den Nachteil, dass die elektrische Verbindung durch eine mangelhafte Verschweißung beeinträchtigt werden kann. Außerdem gestaltet sich die Fertigung je nach Anzahl der Anschlüsse verhältnismäßig aufwendig.

Aus der DE 10 2015 208 425 DE ist eine verbesserte Lösung offenbart, bei der eine Verbindungsstruktur für einen Stator und eine Leiterplatte vorgeschlagen wird, wobei die Verbindungsstruktur Anschlussöffnungen zur Aufnahme von Stator-Lackdrähten umfasst und der Stator und die Leiterplatte elektrisch miteinander verbunden sind. Die Verbindungsstruktur ist gekennzeichnet dadurch, dass sich auf der Leiterplatte weiterhin Anschlussklemmen befinden, die auf solche Weise angeordnet sind, dass die elektrische Verbindung der Leiterplatte mit dem Stator realisiert wird, indem die Anschlussklemmen in die Anschlussöffnungen eingesteckt werden. Als vorteilhafte Ausgestaltung ist dabei eine Lösung vorgeschlagen bei der die Anschlussklemmen so angeordnet sind, dass sie nach dem Einstecken in die Anschlussöffnungen direkt die Lackdrähte kontaktieren und eine leitende Verbindung herstellen, wodurch die elektrische Verbindung des Stators mit der Leiterplatte realisiert wird. Die Anschlussklemmen auf der Leiterplatte und die Anschlussöffnungen am Stator werden direkt ineinander gesteckt, so dass die Anschlussklemmen in die Isolierschicht der Lackdrähte in den Anschlussöffnungen schneiden und eine leitende Verbindung entsteht, wodurch die elektrische Verbindung der Leiterplatte mit dem Stator realisiert wird.

Aus der EP 2 557 665 A1 ist ein Stator für einen Elektromotor, insbesondere für einen Außenläufermotor, umfassend einen Grundkörper mit einem Statorblechpaket, sowie mit auf dem Statorblechpaket angeordneten Statorwicklungen bekannt, die jeweils einen Wickeldrahtanfang und ein Wickeldrahtende aufweisen, wobei jeder Wickeldrahtanfang an Kontaktstiften angeschlossen ist, wobei der Grundkörper mit einer aus Kunststoff bestehenden Hülle umspritzt ist, aus der die Kontaktstifte zumindest teilweise herausragen. Zur Senkung des fertigungstechnischen Aufwands wird vorgeschlagen, dass ein zusammen mit dem Grundkörper von der Hülle umgebener Kontakthalter über das freie Ende der Kontaktstifte auf den Grundkörper aufgeschoben ist, wobei der Kontakthalter die Kontaktstifte mit einem Dichtabschnitt spaltfrei dichtend umfasst.

Die DE 20212273 U1 betrifft einen Stator für einen Elektromotor, insbesondere für einen Außenläufermotor, bestehend aus einem Statorblechpaket mit Statorwicklungen und mindestens einem stirnseitig angeordneten Isolierelement sowie aus einer Verschaltungsanordnung zum Verschalten von Wicklungsdrähten der Statorwicklungen mit elektrischen Anschlußleitungen, wobei in dem Isolierelement elektrische, in Schneid-Klemmtechnik ausgeführte Kontaktelemente zum Kontaktieren der Wicklungsdrähte und der Anschlußleitungen gehaltert sind.

Die EP 0 993 095 A1 beschreibt einen Stator, dessen Verschaltungsanordnung Schneid-Klemmkontaktelemente aufweist, die in speziellen Kontaktkammern des stirnseitigen Isolierelementes sitzen. Konkret soll es sich dabei um mindestens eine Mehrfach-Kontaktkammer handeln, die durch Teilkammern einerseits des an das Blechpaket angespritzten Isolierelementes (Isolier-Endscheibe) und andererseits einer zusätzlichen, wickelkopfseitig aufgesetzten Verdrahtungsplatte derart gebildet ist, dass die Teilkammern im montierten Zustand der Verdrahtungsplatte benachbart nebeneinander angeordnet sind, wobei sie ein gemeinsames, die Teilkammern verbindendes Kontaktelement aufnehmen. Dabei werden bei der Herstellung Enden der Wicklungsdrähte durch die Kontaktkammer geführt. Nach dem Herstellen aller Wicklungen wird die Verdrahtungsplatte auf die Wickelkopfseite des Stators aufgesetzt und befestigt. Es werden dann alle Kontaktkammern mit Schneidklemmkontaktelementen bestückt, indem letztere in die Kammern eingesteckt werden. Dabei erfolgt automatisch eine Kontaktierung der durch die Kontaktkammern verlaufenden Wicklungsdrähte, indem mit einer schlitzförmigen Leiteraufnahme die Isolation durchtrennt und der Draht mit elektrischem Kontakt geklemmt wird (Schneid-Klemmtechnik).

Anschließend werden die äußeren Anschlussleitungen entsprechend der erforderlichen Verschaltung des Stators in Schlitze der Kontaktkammern und Kontaktelemente eingedrückt. Auch hierbei wird die Isolation der Anschlussleitungen durchtrennt und hierdurch der elektrische Kontakt hergestellt. Erst nach diesem Anschluss der äußeren Anschlussleitungen kann die weitere Montage eines Rotors mit seiner Achse erfolgen, und der Motor kann weitere Arbeitsgänge bis zu seiner Fertigstellung durchlaufen. Somit müssen die äußeren Anschlussleitungen jeweils einzeln nacheinander und zudem schon in einem sehr frühen Herstellungsstadium angeschlossen werden. Dies ist vor allem deshalb nachteilig, weil die weitere Herstellung mit den Anschlussleitungen belastet ist, d. h. die Anschlussleitungen könnten den weiteren Herstellungs- und Montageablauf behindern.

Ferner ist aus der WO 2013/098001 A2 ein Elektromotor für Spülmaschinen oder Waschmaschinen offenbart, der den zeitlichen Aufwand bei der Montage reduziert, und die EP 1 037 312 A1 betrifft eine Kontaktanordnung für einen Anschlussblock, der den Platzbedarf für die Schaltungsverbindung reduziert.

Nachteilig bei den zuvor genannten und im Stand der Technik bekannten Lösungen ist der Umstand, dass diese nach wie vor relativ aufwendig und demnach vergleichsweise teuer in der Montage sind und je nach Ausführung immer noch komplexe Anordnungen gegeben sind sowie eine hohe Teilezahl zur Herstellung der Verbindungen mit den Wicklungen der Leiterplatte.

Der Erfindung liegt deshalb die Aufgabe zugrunde, vorbesagte Nachteile zu überwinden und eine kostengünstige, einfache und universelle einsetzbare Lösung für eine Verbindung zwischen einem Stator und einer Leiterplatte vorzusehen.

Diese Aufgabe wird durch die Merkmalskombination gemäß Patentanspruch 1 sowie durch ein Verfahren zur Herstellung einer Verbindung zwischen einem Stator und einer Leierplatte gelöst.

Ein Grundgedanke der vorliegenden Erfindung liegt darin, ein besonders einfaches, kompaktes und effizientes Verbindungskonzept zwischen den Wickeldrähten und der Leiterplatte herzustellen. Hierzu werden auf der Leiterplatte zur elektrischen Kontaktierung mit den Wickeldrähten isolierte Drahtabschnitte in Form von Drahtbrücken, vorzugsweise in oder parallel zur Leiterplatteneben vorgesehen, um diese Drahtbrücken mittels eines Schneidklemmanschlusses eines Schneidklemmkontaktes zu kontaktieren.

Erfindungsgemäß wird daher ein Stator, insbesondere ein Elektromotor-Stator mit einer Leiterplatte vorgeschlagen, umfassend ein Statorgehäuse in bzw. an dem mehrere Wicklungsanordnungen (Statorwicklungen) bestehend aus Wickeldrähten angeordnet sind, wobei ferner Kontaktträgeraufnahmen am Statorgehäuse ausgebildet sind, in denen jeweils ein Schneidklemmkontakteelement eingebracht ist, welches eine elektrische Kontaktierung zwischen jeweils einer Wicklungsanordnung und einer Drahtbrücke auf der Leiterplatte herstellt bzw. herstellen soll.

In einer besonders vorteilhaften Ausgestaltung der Erfindung ist vorgesehen, dass die Schneidklemmkontakteelemente wenigstens einen Schneidklemmverbindungsanschluss bereitstellen, der aus der Kontaktträgeraufnahme (in die das Schneidklemmkontakteelement montiert ist) herausragt und mit seinen Schneidklemmen am Schneidklemmverbindungsanschluss die Isolierung einer auf der Leiterplatte zur Kontaktierung vorgesehenen Drahtbrücke durchdringt.

Besonders vorteilhaft ist es, wenn die jeweilige Drahtbrücke in demjenigen Bereich in dem eine elektrische Verbindung mit einem Schneidklemmkontakteelement hergestellt wird, innerhalb oder parallel zur Erstreckungsebene der Leiterplatte verläuft. Auf diese Weise lässt sich eine besonders einfache Montage in eine insgesamt kompakte Bauform realisieren, da dann die Montagerichtung quer zur Ebene der Leiterplatte verlaufen kann, während die Leiterplatte in Axialrichtung A des Stators an dessen einem Ende direkt oberhalb des Statorgehäuses angeordnet sein kann.

In einer weiteren vorteilhaften Ausgestaltung der Erfindung ist vorgesehen, dass zur Kontaktierung der Schneidklemmkontakteelemente die jeweiligen Drahtbrücken der Leiterplatte mit ihrem Kontaktierungsbereich oberhalb oder unterhalb einer in der Leiterplatte eingebrachten Öffnung verlaufen. Hierdurch lässt sich einerseits eine sehr kompakte Bauform verwirklichen, wärend z. B. durch die Leiterplattenöffnung hindurch zusätzlich eine optische Kontrolle der Schneidklemmverbindung möglich ist.

Anders ausgedrückt bedeutet dies, dass die Schneidklemmkontakteelemente im kontaktierenden Zustand durch die jeweilige dafür vorgesehene Öffnung in der Leiterplatte zumindest mit ihrem stirnseitigen Ende hindurchragen oder dadurch sichtbar sind.

Wird die Leiterbrücke quer unterhalb der Leiterplattenöffnung angebracht, so kann ferner eine besonders kompakte Montage und ein sicheres Durchtrennen der Drahtbrücke innerhalb eines jeden bestückten Kontaktträgers erfolgen, da die Schneidklemmkontakteelemente dann vollständig von der Kontaktträgeraufnahme aufgenommen werden können. In einem solchen Fall ist es weiter von Vorteil, wenn die jeweils zur Verbindung vorgesehene Drahtbrücke als U-förmige Drahtbrücke ausgebildet ist, welche in Richtung zum Statorgehäuse von der Unterseite der Leiterplatte hervorsteht. Im kontaktierenden Zustand verläuft der Kontaktierungsabschnitt der U-förmigen Drahtbrücke innerhalb der Kontaktträgeraufnahme.

In einer besonders vorteilhaften Ausgestaltung der Erfindung ist vorgesehen, dass die Schneidklemmkontakteelemente jeweils als Doppelschneidklemmkontaktelemente mit zwei Schneidklemmverbindungsanschlüssen ausgebildet sind, wobei der eine Schneidklemmverbindungsanschluss den Wickeldraht einer Wicklungsanordnung durchdringt, während der zweite Schneidklemmverbindungsanschluss die Isolierung einer Drahtbrücke auf der Leiterplatte durchdringt.

Ebenfalls von Vorteil ist es, wenn die Kontaktträgeraufnahmen zur Aufnahme der Schneidklemmkontakteelemente taschenartig ausgebildet sind, wobei in die Taschen das jeweilige Schneidklemmkontakteelement in Axialrichtung A des Stators teilweise oder vollständig eingeschoben ist.

Bevorzugt sind die Schneidklemmkontakteelemente mit wenigstens einer Rastnase ausgebildet, welche die Schneidklemmkontakteelemente in der Kontaktträgeraufnahme verrasten bzw. gegen Herausfallen fixieren.

Weiter vorteilhaft ist es, wenn die Drahtbrücken entweder aus einem Lackdraht, einem isolierten Draht oder einer mit einer Isolationsschicht ummantelten drahtförmigen Blechzunge gebildet werden.

Ein weiterer Aspekt der vorliegenden Erfindung betrifft ein Verfahren zum Herstellen einer elektrischen Verbindung zwischen einem wie zuvor beschriebenen Stator und einer Leiterplatte mit den folgenden Schritten:
a) Positionieren einer Leiterplatte, welche Drahtbrücken zur Kontaktierung mit den Wicklungsanordnungen des Stators aufweist relativ zum Stator, derart, dass die korrespondierenden Schneidklemmkontaktelemente axial in der Flucht mit den zu kontaktierenden Drahtbrücken liegen;
b) Zusammenfügen des Stators und der Leiterplatte, so dass die zu den Drahtbrücken korrespondierend angeordneten Schneidklemmkontaktelemente die Isolierung der Drahtbrücke durchdringen und die Drahtbrücke in elektrischen Kontakt mit dem jeweiligen Schneidklemmkontaktelement gebracht wird.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: eine Explosionsdarstellung eines ersten Ausführungsbeispiels eines erfindungsgemäßen Stators ohne Leiterplatte;
- Fig. 2: eine Explosionsdarstellung des erfindungsgemäßen Stators gemäß Figur 1 mit einer Leiterplatte, einmal in einer Vormontagestellung (linke Ansicht) und einmal in einer Kontaktierungsstellung (rechte Ansicht);
- Fig. 3: eine Schnittansicht durch einen Kontaktierungsbereich des ersten Ausführungsbeispiels;
- Fig. 4: eine Explosionsdarstellung eines alternativen Ausführungsbeispiels eines erfindungsgemäßen Stators mit einer zu montierenden Leiterplatte;
- Fig. 5: eine schematische Schnittansicht durch das Ausführungsbeispiels gemäß Figur 4 und
- Fig. 6: eine Schnittansicht durch einen Kontaktierungsbereich des Ausführungsbeispiels nach Figur 4.

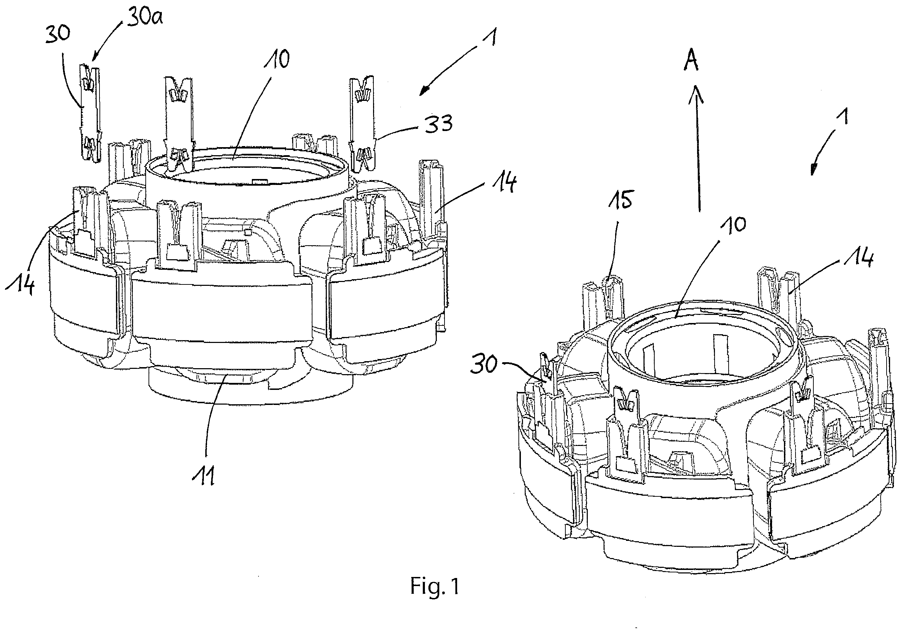

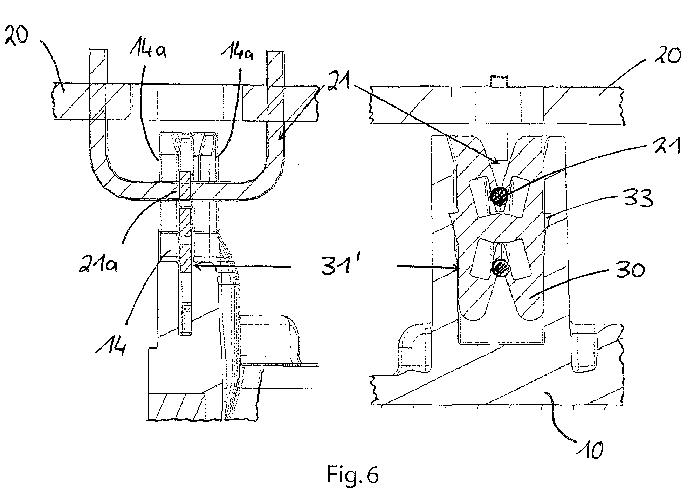

Im Folgenden wird die Erfindung anhand von beispielhaften Ausführungen der Erfindung mit Bezug auf die Figuren 1 bis 6 näher erläutert, wobei gleiche Bezugszeichen auf gleiche strukturelle und/oder funktionale Merkmale hinweisen.

In der Figur 1 ist eine Explosionsdarstellung eines ersten Ausführungsbeispiels eines erfindungsgemäßen Stators 1 für einen nicht näher gezeigten Elektromotor.

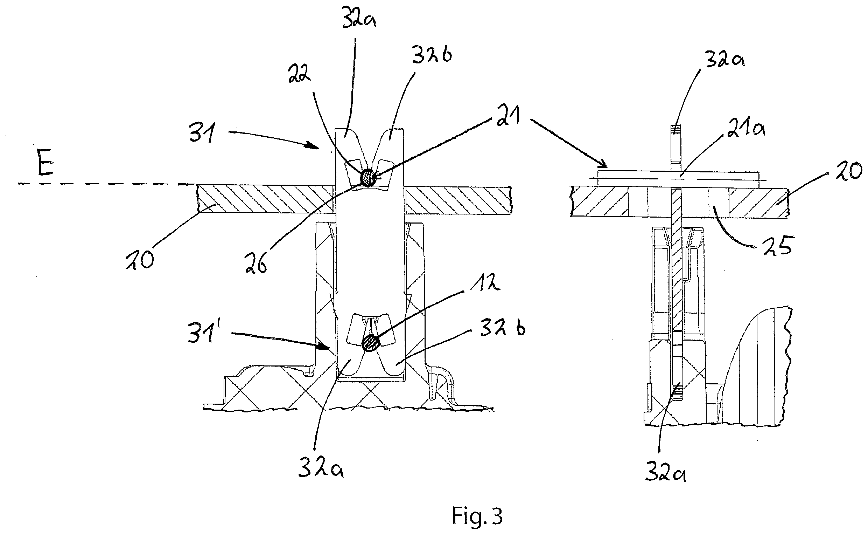

Der Stator 1 umfasst ein Statorgehäuse 10 in dem sechs Wicklungsanordnungen 11 (drei Paare von Statorwicklungen), bestehend aus zu Spulen gewickelten Wickeldrähten 12 angeordnet sind. Am Statorgehäuse 10 sind ferner sechs Kontaktträgeraufnahmen 14 ausgebildet. In der linken Ansicht der Figur 1 sind drei Schneidklemmkontakteelemente 30 oberhalb der taschenförmigen Aufnahmen 15 von drei der vorhandenen Kontaktträgeraufnahmen 14 angeordnet, welche jeweils seitliche hakenartige Rastelemente 33 aufweisen, um sich in dem in der Figur 1 in der rechten Ansicht gezeigten montierten Position in den Taschen 15 der Kontaktträgeraufnahmen 14 zu verhaken (siehe hierzu auch die Schnittansicht in der montierten Position in der Figur 3).

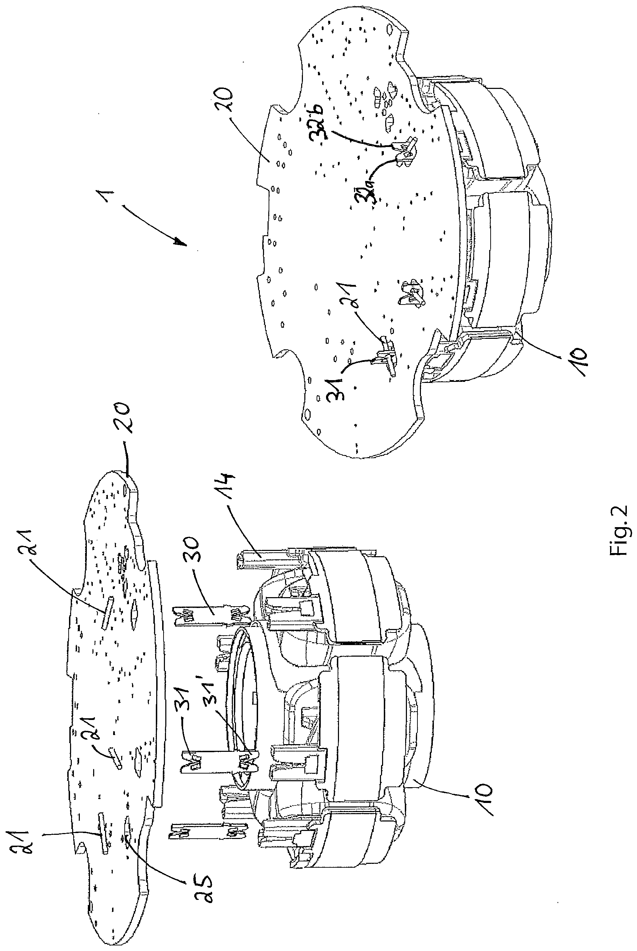

Die elektrische Kontaktierung wird zwischen jeweils einer bestimmten Wicklungsanordnung 10 von einem Paar aus zwei Wicklungsanordnungen 10 und einer dieser Wicklungsanordnung 10 zugeordneten Drahtbrücke 21 der Leiterplatte 20 herstellt, wie dies in der Explosionsdarstellung der Figur 2, einmal in einer Vormontagestellung (linke Ansicht) und einmal in einer Kontaktierungsstellung (rechte Ansicht) näher gezeigt ist.

Bei dieser Ausführungsform stellen die drei Schneidklemmkontakteelemente 30 einen Schneidklemmverbindungsanschluss 31 bereit, der stirnseitig aus der Kontaktträgeraufnahme 14 herausragt und mit seinen Schneidklemmen 32a, 32b die Isolierung 22 einer auf der Leiterplatte vorgesehenen Drahtbrücke 21 durchdringt. Wie in der Figur 2 ebenfalls erkennbar, verläuft die jeweilige Drahtbrücke 21 in demjenigen Bereich in dem eine elektrische Verbindung zwischen dem Leiter 26 mit einem Schneidklemmkontakteelement 30 hergestellt wird, parallel zur Erstreckungsebene E der Leiterplatte 20 und somit quer zur Montagerichtung, die der Axialrichtung A des Stators entspricht.

Die Drahtbrücken 21 der Leiterplatte 20 verlaufen mit ihrem Kontaktierungsbereich 21a jeweils oberhalb von in der Leiterplatte 20 eingebrachten Öffnungen 25.

Die Fig. 3 zeigt eine Schnittansicht durch einen Kontaktierungsbereich des Schneidklemmkontakteelementes 30 des ersten Ausführungsbeispiels.

Die Schneidklemmkontakteelemente 30 sind hier als Doppelschneidklemmkontaktelemente mit zwei Schneidklemmverbindungsanschlüssen 31, 31' ausgebildet, wobei der eine Schneidklemmverbindungsanschluss 31' den Wickeldraht 12 einer Wicklungsanordnung 11 durchdringt, während der zweite Schneidklemmverbindungsanschluss 31 die Isolierung 22 einer Drahtbrücke 21 auf der Leiterplatte 20 durchdringt, wobei die Schneidklemmkontakteelemente 30 mit dem Schneidklemmverbindungsanschluss 31 durch die Öffnungen 25 hindurchragen.

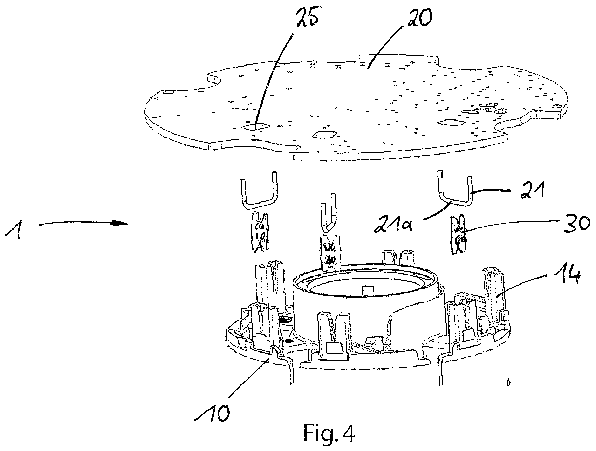

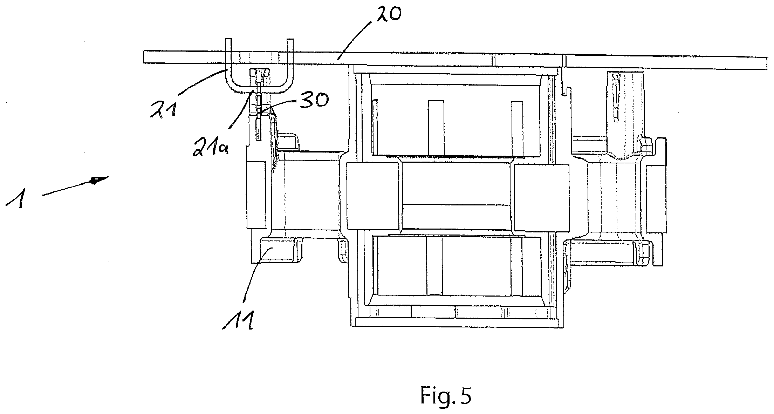

Die Fig. 4 zeigt eine Explosionsdarstellung eines alternativen Ausführungsbeispiels eines erfindungsgemäßen Stators mit einer zu montierenden Leiterplatte und die Fig. 5 eine schematische Schnittansicht durch das Ausführungsbeispiels gemäß Figur 4, wobei die Drahtbrücken 21 U-förmig ausgebildet sind und auf der Unterseite der Leiterplatte 20 hervorstehen.

Ferner ist in der Schnittansicht durch einen Kontaktierungsbereich dieses Ausführungsbeispiels aus Figur 4 erkennbar, dass die Schneidklemmkontakteelemente 30 mit dem Schneidklemmverbindungsanschluss 31 nicht wie im ersten Ausführungsbeispiel stirnseitig aus der Kontaktträgeraufnahme 14 herausragen, sondern die Schneidklemmkontakteelemente 30 vollständig von der Kontaktträgeraufnahme 14 aufgenommen sind. Hierbei ist sicherzustellen, dass die Seitenwände 14a der Kontaktträgeraufnahme 14 seitlich soweit offen sind, dass der Draht der Drahtbrücke tief genug in die Kontaktträgeraufnahme 14 eintauchen kann.

Die Montage erfolgt mit den folgenden Schritten:
i) Positionieren der Leiterplatte 20, welche die passende Anzahl an Drahtbrücken 21 zur Kontaktierung mit den Wicklungsanordnungen 10 des Stators 1 aufweist relativ zum Stator 1, derart, dass die korrespondierenden Schneidklemmkontaktelemente 30 axial in der Flucht mit den zu kontaktierenden Drahtbrücken 21 liegen und
ii) Zusammenfügen des Stators 1 und der Leiterplatte 20, derart dass die zu den Drahtbrücken 21 korrespondierend angeordneten Schneidklemmkontaktelemente 30 die Isolierung der jeweiligen Drahtbrücke 21 durchdringen und die Drahtbrücke 21 in elektrischen Kontakt mit dem jeweiligen Schneidklemmkontaktelement 30 gebracht wird.

## Patentansprüche

1. Stator (1) für einen Elektromotor, verbunden mit einer Leiterplatte (20), umfassend ein Statorgehäuse (10) in dem mehrere Wicklungsanordnungen (11), bestehend aus zu Spulen gewickelten Wickeldrähten (12) angeordnet sind, wobei ferner Kontaktträgeraufnahmen (14) am Statorgehäuse (10) ausgebildet sind, in denen jeweils ein Schneidklemmkontakteelement (30) eingebracht ist, welches eine elektrische Kontaktierung zwischen jeweils einer der Wicklungsanordnungen (10) und einer Drahtbrücke (21) auf der Leiterplatte (20) herstellt, **dadurch gekennzeichnet, dass** die Schneidklemmkontakteelemente (30) mit zwei Schneidklemmverbindungsanschlüssen (31, 31') ausgebildet sind, wobei der eine Schneidklemmverbindungsanschluss (31') den Wickeldraht (12) einer Wicklungsanordnung (11) durchdringt, während der zweite Schneidklemmverbindungsanschluss (31) die Isolierung der entsprechenden Drahtbrücke (21) auf der Leiterplatte (20) durchdringt, wobei
die Kontaktträgeraufnahmen (14) zur Aufnahme der Schneidklemmkontakteelemente (30) taschenartige Aufnahmen (15) ausbilden, in die das jeweilige Schneidklemmkontakteelement (30) in Axialrichtung (A) des Stators (1) eingeschoben ist.

2. Stator (1) gemäß Anspruch 1, **dadurch gekennzeichnet, dass** die Schneidklemmkontakteelemente (30) wenigstens einen Schneidklemmverbindungsanschluss (31) bereitstellen und mit seinen Schneidklemmen (32a, 32b) die Isolierung (22) oder den Leitungsmantel einer unmittelbar auf oder an der Leiterplatte vorgesehenen Drahtbrücke (21) durchdringt.

3. Stator (1) gemäß Anspruch 1 oder 2, **dadurch gekennzeichnet, dass** die jeweilige Drahtbrücke (21) in demjenigen Bereich in dem eine elektrische Verbindung mit einem Schneidklemmkontakteelement (30) hergestellt wird, innerhalb oder parallel zur Erstreckungsebene der Leiterplatte (20) verläuft.

4. Stator (1) gemäß Anspruch 1, 2 oder 3, **dadurch gekennzeichnet, dass** zur Kontaktierung der Schneidklemmkontakteelemente (30) die jeweiligen Drahtbrücken (21) der Leiterplatte (20) mit ihrem Kontaktierungsbereich (21a) oberhalb oder unterhalb einer in der Leiterplatte (20) eingebrachten Öffnung (25) verlaufen.

5. Stator (1) gemäß einem der vorhergehenden Ansprüche, **dadurch gekennzeichnet, dass** die Schneidklemmkontakteelemente (30) mit einer Rastnase (33) ausgebildet sind, welche die Schneidklemmkontakteelemente (30) in der Kontaktträgeraufnahme (14) verrasten.

6. Stator (1) gemäß einem der vorhergehenden Ansprüche, **dadurch gekennzeichnet, dass** die Drahtbrücken (21) aus einem Lackdraht, einem isolierten Draht oder einer mit einer Isolationsschicht (22) ummantelten drahtförmigen Blechzunge gebildet werden.

7. Stator (1) gemäß einem der vorhergehenden Ansprüche 4 bis 7, **dadurch gekennzeichnet, dass** die Schneidklemmkontakteelemente (30) im kontaktierenden Zustand durch die jeweilige Öffnung (25) in der Leiterplatte (20) zumindest mit ihrem stirnseitigen Ende (30a) hindurchragen.

8. Verfahren zum Herstellen einer elektrischen Verbindung zwischen einem Stator (1) gemäß einem der Ansprüche 1 bis 8 und einer Leiterplatte (20) mit den folgenden Schritten:
a) Positionieren einer Leiterplatte (20), welche Drahtbrücken (21) zur Kontaktierung mit den Wicklungsanordnungen (10) des Stators (1) aufweist relativ zum Stator (1), derart, dass die korrespondierenden Schneidklemmkontaktelemente (30) axial in der Flucht mit den zu kontaktierenden Drahtbrücken (21) liegen;
b) Zusammenfügen des Stators (1) und der Leiterplatte (20), so dass die zu den Drahtbrücken (21) korrespondierend angeordneten Schneidklemmkontaktelemente (30) die Isolierung der Drahtbrücke durchdringen und die Drahtbrücke (21) in elektrischen Kontakt mit dem jeweiligen Schneidklemmkontaktelement (30) gebracht wird.

## Claims

1. Stator (1) for an electric motor, connected to a circuit board (20), comprising a stator housing (10) in which several winding arrangements (11) consisting of winding wires (12) wound to form coils are arranged, wherein, furthermore, contact support receptacles (14) are formed on the stator housing (10), receptacles in which, in each case, an insulation displacement contact element (30) is introduced, which establishes an electrical contact between, in each case, a winding arrangement (10) and a jumper wire (21) on the circuit board (20), **characterized in that** the insulation displacement contact elements (30) are formed as double insulation displacement contact elements with two insulation displacement contact connecting terminals (31, 31'), wherein one insulation displacement contact connecting terminal (31') cuts through the winding wire (12) of a winding arrangement (11), while the second insulation displacement contact connecting terminal (31) cuts through the insulation of a jumper wire (21) on the circuit board (20), wherein for receiving the insulation displacement contact elements (30), the contact support receptacles (14) form pocket-like receptacles (15), into which the respective insulation displacement contact element (30) is inserted in axial direction (A) of the stator (1).

2. Stator (1) according to claim 1, **characterized in that** the insulation displacement contact elements (30) provide at least one insulation displacement contact connecting terminal (31) and, with the insulation displacement terminations (32a, 32b) thereof, cuts through the insulation (22) or the cable sheath of a jumper wire (21) provided directly on or at the circuit board.

3. Stator (1) according to claim 1 or 2, **characterized in that** the respective jumper wire (21) extends in the area in which an electrical connection with an insulation displacement contact element (30) is established, within or parallel to the plane of extension of the circuit board (20).

4. Stator (1) according to claim 1, 2 or 3, **characterized in that** for the contacting of the insulation displacement contact elements (30), the respective jumper wires (21) of the circuit board (20) with the contacting area (21a) thereof extend above or below an opening (25) made in the circuit board (20).

5. Stator (1) according to one of the preceding claims, **characterized in that** the insulation displacement contact elements (30) are formed with a catch (33), which catches the insulation displacement contact elements (30) in the contact support receptacle (14).

6. Stator (1) according to one of the preceding claims, **characterized in that** the jumper wires (21) are formed from an enameled wire, from an insulated wire, or from a wire-shaped sheet metal tab sheathed by an insulation layer (22).

7. Stator (1) according to one of the claims 4 to 6, **characterized in that**, in the contacting state, the insulation displacement contact elements (30), at least by the front-side end (30a) thereof, protrude through the respective opening (25) in the circuit board (20).

8. A method for producing an electrical connection between a stator (1) according to one of the claims 1 to 7 and a circuit board (20), with the following steps:
a) positioning of a circuit board (20), which comprises jumper wires (21) for the contacting with the winding arrangements (10) of the stator (1), relative to the stator (1), in such a manner that the corresponding insulation displacement contact elements (30) are axially aligned with the contacting jumper wires (21);
b) assembly of the stator (1) and of the circuit board (20), so that the insulation displacement contact elements (30) arranged correspondingly with respect to the jumper wires (21) cut through the insulation of the jumper wire, and the jumper wire (21) is brought in electrical contact with the respective insulation displacement contact element (30).

## Revendications

1. Stator (1) pour un moteur électrique, relié à un circuit imprimé (20), comprenant un boîtier de stator (10) dans lequel plusieurs agencements d'enroulement (11), constitués de fils de bobinage (12) bobinés en bobines, sont agencés, dans lequel en outre des logements de support de contact (14) sont réalisés au niveau du boîtier de stator (10), dans lesquels respectivement un élément de contact à déplacement d'isolation (30) est introduit, lequel établit un contact électrique entre respectivement un des agencements d'enroulement (10) et un pont à fil (21) sur le circuit imprimé (20), **caractérisé en ce que** les éléments de contact à déplacement d'isolation (30) sont réalisés avec deux bornes de connexion à déplacement d'isolation (31, 31'), dans lequel l'une borne de connexion à déplacement d'isolation (31') traverse le fil de bobinage (12) d'un agencement d'enroulement (11), pendant que la deuxième borne de connexion à déplacement d'isolation (31) traverse l'isolant du pont à fil (21) correspondant sur le circuit imprimé (20), dans lequel
les logements de support de contact (14) forment des logements en forme de poche (15) pour le logement des éléments de contact à déplacement d'isolation (30), dans lesquels l'élément de contact à déplacement d'isolation (30) respectif est inséré dans la direction axiale (A) du stator (1).

2. Stator (1) selon la revendication 1, **caractérisé en ce que** les éléments de contact à déplacement d'isolation (30) mettent à disposition au moins une borne de connexion à déplacement d'isolation (31) et traverse avec ses connecteurs auto-dénudants (32a, 32b) l'isolant (22) ou la gaine de câble d'un pont à fil (21) prévu directement sur ou au niveau du circuit imprimé.

3. Stator (1) selon la revendication 1 ou 2, **caractérisé en ce que** le pont à fil (21) respectif s'étend dans la zone, dans laquelle une connexion électrique est établie avec un élément de contact à déplacement d'isolation (30), à l'intérieur ou parallèlement au plan d'extension du circuit imprimé (20).

4. Stator (1) selon la revendication 1, 2 ou 3, **caractérisé en ce que** pour la mise en contact des éléments de contact à déplacement d'isolation (30), les ponts à fil (21) respectifs du circuit imprimé (20) s'étendent avec leur zone de mise en contact (21 a) au-dessus ou en dessous d'une ouverture (25) ménagée dans le circuit imprimé (20).

5. Stator (1) selon l'une quelconque des revendications précédentes, **caractérisé en ce que** les éléments de contact à déplacement d'isolation (30) sont réalisés avec un ergot d'encliquetage (33), lesquels encliquètent les éléments de contact à déplacement d'isolation (30) dans le logement de support de contact (14).

6. Stator (1) selon l'une quelconque des revendications précédentes, **caractérisé en ce que** les ponts à fil (21) sont formés d'un fil émaillé, d'un fil isolé ou d'une languette de tôle en forme de fil enveloppé d'une couche isolante (22).

7. Stator (1) selon l'une quelconque des revendications précédentes 4 à 7, **caractérisé en ce que** les éléments de contact à déplacement d'isolation (30) traversent à l'état de contact l'ouverture (25) respective dans le circuit imprimé (20) au moins avec leur extrémité côté frontal (30a).

8. Procédé d'établissement d'une connexion électrique entre un stator (1) selon l'une quelconque des revendications 1 à 8 et un circuit imprimé (20) avec les étapes suivantes :
a) positionnement d'un circuit imprimé (20), lequel présente des ponts à fil (21) pour la mise en contact avec les agencements d'enroulement (10) du stator (1) par rapport au stator (1), de sorte que les éléments de contact à déplacement d'isolation (30) correspondants se trouvent axialement dans l'alignement des ponts à fil (21) à mettre en contact ;
b) assemblage du stator (1) et du circuit imprimé (20), de sorte que les éléments de contact à déplacement d'isolation (30) agencés de manière correspondante par rapport aux ponts à fil (21) traversent l'isolant du pont à fil et le pont à fil (21) est mis en contact électrique avec l'élément de contact à déplacement d'isolation (30) respectif. .
